# EUROPEAN PATENT SPECIFICATION

(11) **EP 1 798 861 B1**
(45) Date of publication and mention of the grant of the patent: **05.11.2008**
(21) Application number: 06123885.3
(22) Date of filing: 10.11.2006
(51) Int. Cl.: H03M 13/11

(54) **LDPC encoding through decoding algorithm**
LDPC Codierung durch Decodieralgorithmus
Codage LDPC par algorithme de décodage

(30) Priority: 15.12.2005 KR 20050124111
(43) Date of publication of application: 20.06.2007
(73) Proprietor: Samsung Electronics Co., Ltd., Seoul 442-742 (KR)
(72) Inventor: Hwang, Sung-hee 150-1401 Hwanggol, Yeongtong-gu Suwon-si Gyeonggi-do (KR); Kim, Hyun-jung, Yeongtong-gu Suwon-si Gyeonggi-do (KR); Hong, Jin-seok 924-704 Byeokjeokgol, Suwon-si Gyeonggi-do (KR)
(74) Representative: Brandon, Paul Laurence

(56) References cited:
- EP-A- 1 610 466
- EP-A2- 1 511 177
- US-A1- 2004 148 560
- VILA CASADO A I ET AL: "Multiple rate low-density parity-check codes with constant blocklength" 2004. CONFERENCE RECORD OF THE THIRTY-EIGHTH ASILOMAR CONFERENCE ON SIGNALS, SYSTEMS AND COMPUTERS, PACIFIC GROVE, CA, USA NOV. 7-10, 2004, PISCATAWAY, NJ, USA,IEEE, 7 November 2004 (2004-11-07), pages 2010-2014, XP010781157 ISBN: 0-7803-8622-1
- SCHLEGEL C, PEREZ L: "Trellis and Turbo Coding" March 2004 (2004-03), WILEY-IEEE PRESS , PISCATAWAY, NJ, US , XP002425730 * the whole document *
- VONTOBEL O: "Algebraic Coding for Iterative Decoding" July 2003 (2003-07), HARTUNG-GORRE VERLAG , KONSTANZ (DE) , XP002425731 ISSN: 1616-671X ISBN: 3-89649-865-7 Chapter "5.10 Codeword Generation", pages 130-133 * the whole document *
- HALEY D ET AL: "Iterative encoding of low-density parity-check codes" GLOBECOM'02. 2002 - IEEE GLOBAL TELECOMMUNICATIONS CONFERENCE. CONFERENCE PROCEEDINGS. TAIPEI, TAIWAN, NOV. 17 - 21, 2002, IEEE GLOBAL TELECOMMUNICATIONS CONFERENCE, NEW YORK, NY : IEEE, US, vol. VOL. 1 OF 3, 17 November 2002 (2002-11-17), pages 1289-1293, XP010636353 ISBN: 0-7803-7632-3
- HOCEVAR D: "Efficient encoding for a family of quasi-cyclic LDPC codes" GLOBECOM'03. 2003 - IEEE GLOBAL TELECOMMUNICATIONS CONFERENCE, SAN FRANCISCO, DEC. 1 - 5, 2003, vol. VOL. 7 OF 7, 1 December 2003 (2003-12-01), pages 3996-4000, XP010677362 ISBN: 0-7803-7974-8

## Description

Aspects of the present invention relate to an encoding method and an error correction apparatus.

According to the high density of information storage media and data transmission, data playback per unit time or transmission quantity increase in a communication channel when transmitting data through wired, wireless, and/or optical communication devices. Therefore, many errors can occur when a channel situation worsens. For example, since more data can be stored in a high-density optical storage medium, more errors occur due to dust, scratches, fingerprints, etc. Additionally; since an amount of data transmission per unit time increases with high density data in wired/wireless communication, an amount of errors, which are contained in the data received with respect to a communication failure during the same time, relatively increases. An error correction method or an error correction code, which has a high error correction capability, is required according to the high-density data.

A soft iterative decoding method, such as a conventional Reed-Solomon (RS) code, in which error correction is not performed with hard values (for example, 0 or 1) of inputted bits, is used to perform error correction through repetitive correction by referring to soft values (for example, 0.2 or 0.9) of an inputted bit as an error correction code and a method such as turbo ' code decoding and low density parity check (LDPC) decoding. The soft value of the inputted bit can be represented with probability of the inputted hard value.

A linear block code, such as the RS code or the LDPC code, includes a parity check matrix, H, that satisfies HC^{T} = 0 with respect to a given codeword vector, C. Additionally, there is a generator matrix, G, in the given H, which satisfies m*G = C. Here, m and C represent a message vector and a codeword vector, respectively. That is, the message vector, m, can be obtained by encoding through converting the message vector into the codeword vector with the generator matrix, G, and decoding the received codeword vector with the parity check matrix, H, in the linear block code. Accordingly, a separate additional hardware for encoding and decoding must be configured to apply the message vector to an optical storage medium or an actual system (i.e. wired/wireless communication systems, computer systems, etc.).

A method of performing the RS encoding and the RS decoding using a single RS decoder to reduce the hardware load is disclosed in United States Patent No. 5,771,244. The reason that a single RS decoder can perform encoding is as follows. The RS decoder searches and corrects the error position and the value of the codeword vector through an algebraic method of the received codeword vector using the parity check matrix H, and uses an erasure correction method to perform a correction by obtaining the error position in advance during the encoding. The message vector becomes the codeword vector by adding additional information (i.e., parity). At this point, a portion where the parity is added is regarded as an error in advance, the message vector is determined, and the codeword vector is inputted into the RS decoder. Then, the RS decoder performs the encoding through the erasure correction about the received codeword vector to generate the actual parity vector about the message vector. However, there is a problem that this method cannot be applied to a system performing the decoding through iteration, such as the turbo code or the LDPC code.

US 2004/0148560 discloses a method of encoding an N-M dimension data message vector according to the pre-characterizing portion of claim 1.

EP-A-1511177 discloses a parity check matrix having a full-rank portion H_{P} containing a group of rows of weight 1 and further groups of rows in which a row of group I can be made weight-1 by adding thereto rows of groups 1 to i-1.

Casado A, "Multiple Rate Low-Density Parity-Check Codes with Constant Blocklength", pages 2010-2014, ASILOMAR'2004 discloses a method of encoding an n-m dimension data message vector according to the pre-characterizing portion of claim 1.

Vontobel P., "Algebraic Coding for Iterative Decoding" July 2003, Hartung Gorre Verlag, Konstanz (DE), chapter 5, section 5.10 "Codeword generation", pages 130-133 discloses that the error recovery capability of a LDPC decoder allows the recovery of the parity symbols initialized as erasures, hence effectively encoding a LDPC codeword by performing a decoding operation.

Schlegel C, "Trellis and Turbo Coding", March 2004, Wiley-IEEE press, pages 277-280, section "9.9 Encoding via Message-Passing", pages 277-280 discloses that if Hₚ is truly lower triangular, then the BEC decoding algorithm can be used to perform iterative encoding in at most m steps.

Haley D, "Iterative encoding of Low-Density Parity-Check Codes", GLOSECOM'02, pages 1289-1293 discloses that LDPC's having a parity-check matrix H with parity portion H_{pm x m} which can be made upper triangular using only row and column permutations can be encoded in at most m message-passing iterations using the sum-product algorithm when initializing the parity bits with erasures.

Preferred embodiments of the present invention aim to provide a parity check matrix making it possible to encode through decoding, a method of generating a parity check matrix, an encoding method, and an error correction apparatus.

According to the present invention, there is provided a method of encoding an N-M dimension data message vector, the encoding method comprising: generating an M × N parity check matrix, H = [Hₘ|Hₚ], by generating an M × M sub-matrix, Hₚ, of the parity check matrix H, comprising an M number of row vectors that are linearly independent, a set A of the M number of the row vectors such that the set A is a union set of subsets A₁, A₂, ..., Aₖ, where 1 ≤ k ≤ M, that do not include intersection sets with each other and are not empty sets, the subset A₁ is a set of weight one row vectors among the row vectors of the set A, and a subset A₁ (2 ≤ i ≤ k) is a set of row vectors capable of deriving the weight one row vector by performing a linear combination with row vectors in a union set of the subsets A₁, ..., Aᵢ₋₁ among row vectors not included in the union set of the subsets A₁, ..., Aᵢ₋₁; and encoding the message vector by setting an entire parity vector with 0s, replacing 0s of the message vector with -1s, and adding the parity vector having an M dimension to the message vector through soft-iterative decoding using the generated parity check matrix; wherein the generating of the M × N parity check matrix comprises: defining the parity check matrix to have a block structure, wherein M = 8*B, where B is an integer greater than one; and generating at least a B number of weight one column vectors in the sub-matrix Hₚ.

Further features of the present invention are set out in the appended claims.

The present invention will become apparent and more readily appreciated from the following description of the embodiments, taken in conjunction with the accompanying drawings of which:
FIG. 1 is a sub-matrix, Hₚ, of an M × N parity check matrix, H = [Hₘ|Hₚ], according to an embodiment of the present invention;
FIG. 2 is a sub-matrix, Hₚ, of an M × N parity check matrix, H = [Hₘ|Hₚ], according to another embodiment of the present invention;
FIG. 3A is a sub-matrix, Hₚ, of an M × N parity check matrix, H = [Hₘ|Hₚ], according to still another embodiment of the present invention;
FIG. 3B is a sub-matrix, Hₚ, of an M × N parity check matrix, H = [Hₘ|Hₚ], according to another embodiment of the present invention;
FIG. 4A is a diagram illustrating a connection between a parity check node and a bit node of a sub-matrix, Hₚ, in FIG. 1, according to an embodiment of the present invention;
FIG. 4B is a diagram illustrating a connection between a parity check node and a bit node of a sub-matrix, Hₚ, in FIG. 2, according to another embodiment of the present invention;
FIG. 5 is a flowchart illustrating an encoding method by decoding according to an embodiment of the present invention;
FIG. 6 is a configuration diagram of an error correction apparatus according to an embodiment of the present invention; and
FIGs. 7A through 7D are diagrams to explain encoding processes according to an embodiment of the present invention

Reference will now be made in detail to the present embodiments of the present invention, examples of which are illustrated in the accompanying drawings, wherein like reference numerals refer to the like elements throughout. The embodiments are described below in order to explain the present invention by referring to the figures.

Encoding is generally classified into systematic encoding and non-systematic encoding. In systematic encoding, original values are maintained in a message vector, and a codeword is generated by adding a parity vector. That is, a portion corresponding to a message vector of a codeword encoded using the systematic encoding method has the same values as an original message vector. On the other hand, in non-systematic encoding, the values of the message vector are changed into other values.

According to an embodiment of the present invention, a parity check matrix making it possible to perform the systematic encoding by decoding is defined as follows.

The parity check matrix is defined as an M × N matrix, H, having an M number of linearly independent rows in a vector space of a growth factor, GF(2). Additionally, an M × M sub-matrix, H_{P}, of the matrix H is defined to have the following structure.

Definition 1: let's assume that a set of the M number of row vectors is A.

Definition 2: let's assume that a number of non-zero elements among each element of vectors is weight (i.e., the weight of a vector V = (1, 0, 0, 0, 1, 0, 0) is two).

Definition 3: let's assume that a set of elements with weight one among elements of a set A is A₁.

The subset A₁ of the set A is not an empty set.

If a difference set, B₁ = A - A₁, of the set A and the set A₁ is not an empty set, the set B₁ incudes a subset, A₂, of the set B₁ with vectors, and the subset A₂ is not an empty set. If a weight one vector can be obtained by a linear combination of v and the vectors of the A₁ with respect to an element vector v of the set B₁, the vector v is an element of A₂.

If a difference set B₂ = A- (A, u A₂) is not an empty set, the set B₂ includes a subset A₃ of the set B₂ with vectors, and A₃ is not an empty set. If a weight one vector can be obtained by a linear combination of v and A₁ u A₂ vectors with respect to an element vector v of the set B₂, the vector v is an element of A₃.

Using the above formula, a variable, k, makes a difference set, Bₖ = A - (A, ∪ A₂ ∪ ... ∪ Aₖ), become an empty set (i.e. A = (A₁ ∪ A₂ ∪ ... u Aₖ)), and is equal to or more than 1 and equal to or less than M.

The M number of row vectors of Hₚ are linearly independent.

To summarize, the parity check matrix is defined with the structure of an M × N matrix, H = [Hₘ|Hₚ]. In the M × M sub-matrix Hₚ of the M × N matrix H = [Hₘ|Hₚ], all row vectors are linearly independent, a set, A, of all the row vectors is a union set of subsets A₁, A₂, ..., Aₖ (1 ≤ k ≤ M) that do not include intersection sets mutually and are not empty sets, the subset A₁ is a set of weight one row vectors among the elements of the set A, and the subset A₁ (2 ≤ i ≤ k) is a set of row vectors capable of deriving a weight one row vector through a linear combination with row vectors in the union set of the subset A₁, ..., Aᵢ₋₁ among the row vectors not included in the union set of the subset A₁, ..., Aᵢ₋₁. Additionally, it is desirable that the parity check matrix does not include four cycles. When the four cycles are included, performance of the parity check matrix is significantly reduced.

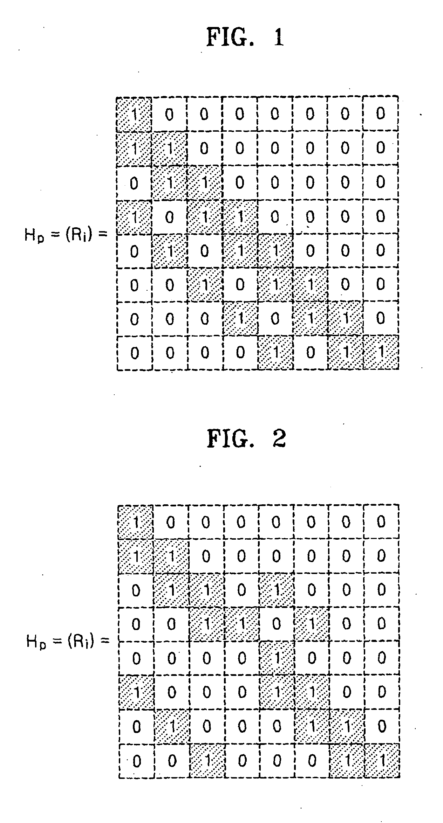

FIG. 1 is a sub-matrix, Hₚ, of an M × N parity check matrix, H = [Hₘ|Hₚ], according to an embodiment of the present invention. Referring to FIG. 1, M is 8 and Rᵢ (i = 1, 2,..., 8) represents an i^{th} row vector. Also, k is 8, and Aᵢ has one row vector with respect to each i and is identical to {Rᵢ}.

FIG. 2 is a sub-matrix, Hₚ, of an M × N parity check matrix, H = [Hₘ|Hₚ], according to another embodiment of the present invention. Referring to FIG. 2, M is 8 and Rᵢ(i = 1, 2,..., 8) represents an i^{th} row vector. Also, k is 4 and A₁ = {Rᵢ, R₅}, A₂ = {R₂, R₆}, A₃ = {R₃, R₇}, A₄ = {R₄, R₈}.

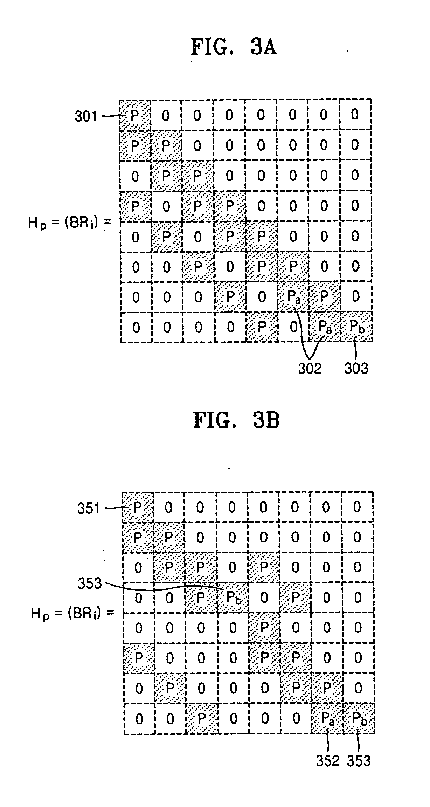

FIG. 3A is a sub-matrix, Hₚ, of an M × N parity check matrix, H = [Hₘ|Hₚ], according to still another embodiment of the present invention. FIG. 3B is a sub-matrix, Hₚ, of an M × N parity check matrix, H = [Hₘ|Hₚ], according to another of the present invention.

Referring to FIGs. 3A and 3B, M is 8*B and B is an integer greater than 1. That is, the sub-matrices, Hₚ, of FIGs. 1 and 2 are expanded into the sub-matrices, Hₚ, of FIGs. 3A and 3B, which respectively illustrate a sub-matrix, H_{P}, of H satisfying the definition according to an aspect of the present invention when the parity check matrix H is made of a block structure. BRᵢ (I = 1, 2, ..., 8) is a B X 8*B. For example, BR₁ is B X 8*B (P 0 0 0 0 0 0 0) having a first B number of row vectors of H. P(301, 351) is a B X B unit matrix I or a permutation matrix of the B X B unit matrix I by row-shifting the B X B unit matrix I. It is desirable that a girth (the shortest cycle length in the matrix H) is more than 6 in the P(301, 351) obtained by row-shifting the B X B unit matrix I. That is, it is desirable that the shift value is determined in order not to have four cycles. Additionally, 0 represents B X B zero matrix in FIGs. 3A and 3B.

As illustrated in FIGs. 1 and 2, H includes at least one column vector with weight one. When there is a weight one column, the performance of the parity check matrix is more or less reduced due to the parity check matrix characteristics. When the H_{P} structure is designed with a B X B block structure as illustrated in FIGs. 3A and 3B, at least a B number of weight one columns is included. Since it is desirable to minimize the number of weight one columns, it is necessary that Pₐ (302, 352) includes a B X B matrix with weight one or two columns, and also P_{b} (303, 353) includes a B X B matrix satisfying the characteristics in FIG 1 or FIG 2.

When P_{b} is a permutation matrix of the BXB unit matrix I, Aᵢ = {v|v = a row vector of BRᵢ}, where k = 8 and i = 1, 2, ..., 8 in FIG. 3A, and there are a B number of weight one column vectors. In FIG. 3B, k = 4, A₁ = {v|v = a row vector of BR₁ or BR₅}, A₂ = {v|v = a row vector of BR₂ or BR₆}, A₃ = {v|v = a row vector of BR₃ or BR₇}, A₄ = {v|v = a row vector of BR₄ or BR₈}, and also there are a 2*B number of weight one column vectors.

On the other hand, when P_{b} has the same structure as FIG 1, k = 7 + B, Aᵢ= {v|v = a row vector of BRᵢ}, where i = 1, 2, ..., 7, Aᵢ₊₇ = {v|v = a i^{th} row vector of BR₈}, where i = 1, 2, ..., B, and also there is one column vector with weight one in FIG. 3A. In FIG 3B, k = 3 + B, A₁ = {v|v = a row vector of BR₁ or BR₅}, A₂ = {v|v = a row vector of BR₂ or BR₆}, A₃ = {v|v = a row vector of BR₃ or BR₇}, A₃₊ᵢ = {v|v = a i^{th} row vector of BR₄ or BR₈}, where i = 1, 2, ..., B and also there are two column vectors with weight one.

The encoding time is proportional to k. Additionally, the error correction performance of the parity check matrix deteriorates when the number of weight one column vectors increases. As described above, since k and the number of weight one column vectors can be controlled, it is desirable that an appropriate structure is selected considering the encoding time and the performance of H in the block structure.

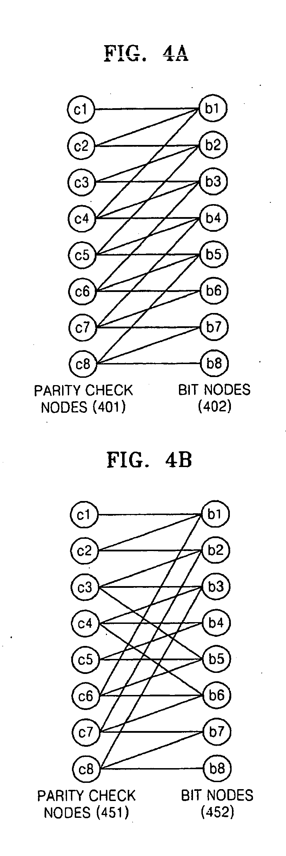

FIG 4A is a diagram illustrating a connection between a parity check node 401 and a bit node 402 of a sub-matrix, Hₚ, in FIG 1, according to an embodiment of the present invention. FIG. 4B is a diagram illustrating a connection between a parity check node 451 and a bit node 452 of a sub-matrix, Hₚ, in FIG. 2, according to another embodiment of the present invention.

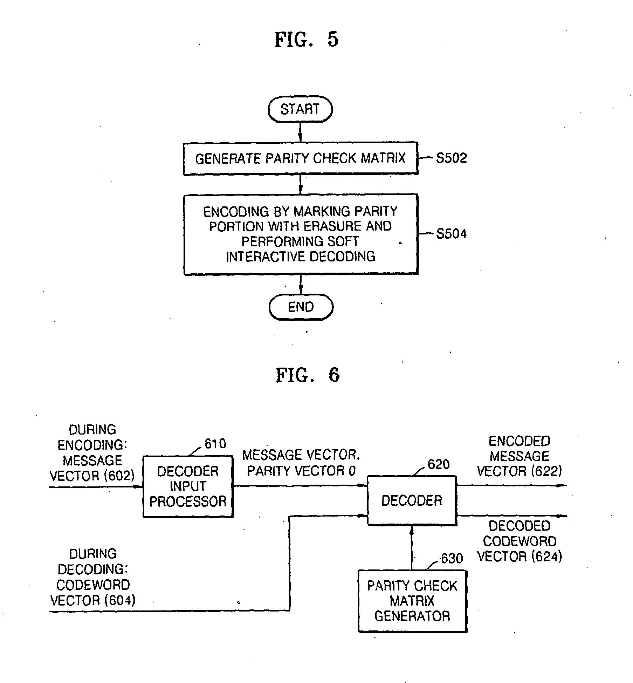

FIG 5 is a flowchart illustrating an encoding method by decoding according to an embodiment of the present invention. Referring to FIG 5, a parity check matrix, which satisfies the above-mentioned definition of an M × N matrix, H = [Hₘ|Hₚ], is generated in operation S502. A message vector is then encoded into a codeword vector by decoding using the generated parity check matrix. In operation S504, a soft iterative decoding can be used as the decoding method, and in this case, the soft iterative decoding method is performed by setting an entire parity portion to 0s. Since values of the parity part can be obtained through the decoding result, the encoding through the decoding is possible. However, as described below, the encoding is possible through the decoding in addition to the soft iterative decoding. The encoding method using the decoding will be described in more detail.

To perform the encoding with one decoder, information to determine whether the encoding or the decoding has been selected is received. When the encoding has been selected, the parity vector P(x) is obtained using an algebraic method or the soft iterative decoding method.

Let's assume that the parity check matrix is H = [Hₘ|Hₚ]. Here, Hₘ is an M × (N - M) sub-matrix. When an M dimension parity vector about the given N - M dimension message vector M(x) is P(x) = (P₁, P₂, ..., P_{M}), a codeword vector C(x) - (M(x), P(x)) needs to satisfy HC^{T}= HₘM^{T} + HₚP_{T} = 0 (M dimension zero vector). That is, a matrix product of all row vectors of H and C^{T} needs to be zero above the growth factor, GF(2). Consequently, when the M dimension parity vector satisfying HC^{T} = 0 about the given M(x) is obtained, it indicates that the encoding is possible through the decoding.

First, the decoding process using the algebraic method will be explained. Firstly, let's assume that P₀(x)= (x₁, x₂, ..., x_{M}). These values (x₁, x₂, ..., x_{M}) are predetermined arbitrary values. At this point, C₀(x) = (M(x), P₀(x)). When using the algebraic method, M(x) can be encoded into C(x) by a k-step decoding.

### Operation 1: performing the decoding by a set A₁.

A matrix product of a row vector of H, including row vectors in the set A₁, and C₀^{T} needs to be zero. Additionally, since the weight of the row vector in the set A₁ is one, an element xᵢ₁ of a parity vector P₀(x) corresponding to a value one element in the row vector obtains only solution Pᵢ₁ using a linear equation. As a result, P₀(x) is decoded into P₁(x) = (x₁, ..., Pᵢ₁, ...., x_{M}) by the set A₁. Let's assume that C₁(x) = (M(x), P₁(x)).

### Operation 2: performing the decoding by a set A₂ with the decoding result of the operation 1.

A matrix product of a row vector of H, including row vectors in the set A₂, and C₁^{T} needs to be zero. Additionally, since the row vector in the set A₂ can generate a weight one row vector through a linear combination with row vectors in the set A₁, an element xᵢ₂ of a parity vector P₁(x) corresponding to a value one element in the row vector has only solution Pᵢ₂ by a linear equation. As a result, P₁(x) is decoded into P₂(x) = (x₁, ..., Pᵢ₁, ...., Pᵢ₂, ..., x_{M}) by the set A₂. Let's assume that C₂(x) = (M(x), P₂(x)).

### Operation k: performing the decoding by Aₖ with the decoding result of operation (k-1).

A matrix product of a row vector of H, including row vectors in the set Aₖ, and Cₖ₋₁^{T} needs to be zero. Additionally, since the row vector in the set Aₖ can generate a weight one row vector through a linear combination with row vectors in the A₁ + A₁ + ... + Aₖ₋₁, an element xᵢₖ of a parity vector Pₖ₋₁(x) corresponding to a value one element in the row vector has only solution Pᵢₖ by a linear equation. As a result, Pₖ₋₁(x) is decoded into P(x) = (P₁, P₂, ..., P_{M}) by the set Aₖ. When C(x) = (M(x); P(x)), C(x) is an encoded codeword of M(x).

Second, an encoding method by the soft iterative decoding using a log likelihood ratio (LLR) like "MIN" approximation (approximation of a sum-product and a sum-product) will be explained.

In this case, when M(x) is converted into M'(x) = 2*M(x)-1, and C'(x) = (M'(x), P'(x)) is inputted into the iterative decoder by setting P'(x) = 0, C(x) = (M(x), P(x)) that satisfies HC^{T} = 0 is decoded by at most a·k number of the iteration. At this point, P'(x) is set to be 0s for an erasure mark because the encoding is performed using an erasure correction.

Since M'(x) does not contain any error, a value of the element is 1 or -1, and P'(x) is all 0s, the element values of P(x) corresponding to a position, where an element of a row vector in the set A₁ is 1, are corrected by a first correction because of the soft iterative decoding characteristics. When a result of the first correction is C₁(x), a correction is completed when HC₁^{T} = 0; otherwise a second repetitive correction is performed. At this point, since a weight one row vector can be derived from row vectors of a set A₂ through a linear combination with the row vectors of the A₁, an element of the derived weight one row vector corrects an element value of P(x) corresponding to a position of weight one. When a result of the second correction is C₂(x), correction is completed when HC₂^{T}= 0; otherwise a repetitive correction is performed. Through this method, all element values of P(x) are corrected by at least a kth correction. Consequently, C'(x) is corrected into C(x) = (M(x), P(x)) by at most a k number of iterative decoding. That is, the message vector M(x) is encoded into a codeword with the parity vector.

FIG. 6 is a configuration diagram of an error correction apparatus according to an embodiment of the present invention. The error correction apparatus includes a parity check matrix generator 630 generating an M × N parity check matrix, H, and a decoder 620 performing decoding using the generated parity check matrix H. The decoder 620 outputs an encoded message vector 622 by obtaining an M dimension parity vector to be added to an N - M dimension message vector 602 during encoding, and outputs a decoded codeword 624 after decoding the received codeword vector 604 during decoding. Additionally, when using a soft iterative decoder as the decoder 620, the error correction apparatus further includes a decoder input processor 610 to replace 0s in the inputted message vector 602 with -1s and to input a parity vector set with 0s into the decoder 620 during encoding.

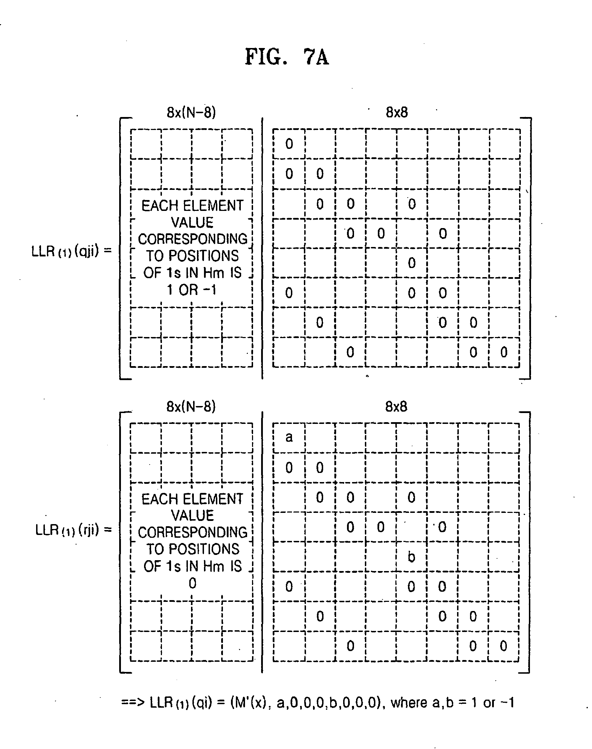

FIGs. 7A through 7D are diagrams explaining encoding processes through decoding according to an embodiment of the present invention. Through the illustrated processes, C(x) satisfying HC^{T} = 0 is obtained using an encoding method through soft iterative decoding, and the soft iterative decoding is performed using the parity check matrix H of FIG. 2. First, let's input C'(x) = (2*M(x) - 1,0) for the soft iterative decoding. That is, when the value of a message part of the codeword C'(x) is 1, the value 1 remains and when the value of the message portion is 0, the value 0 is changed into -1. Additionally, a parity portion is set to 0s for erasure correction, and then inputted into the soft iterative decoder.

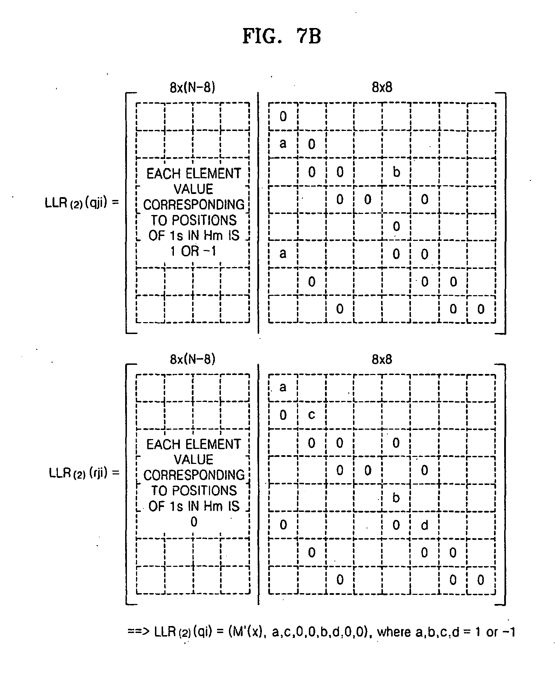

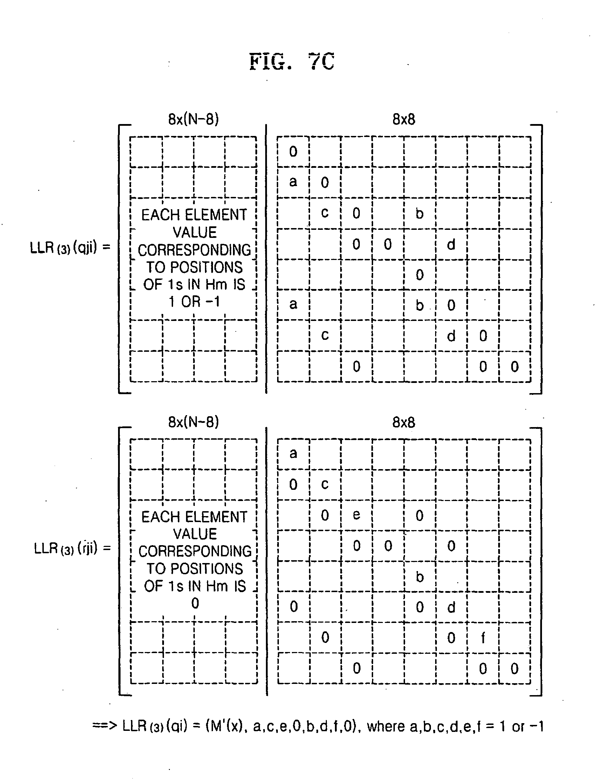

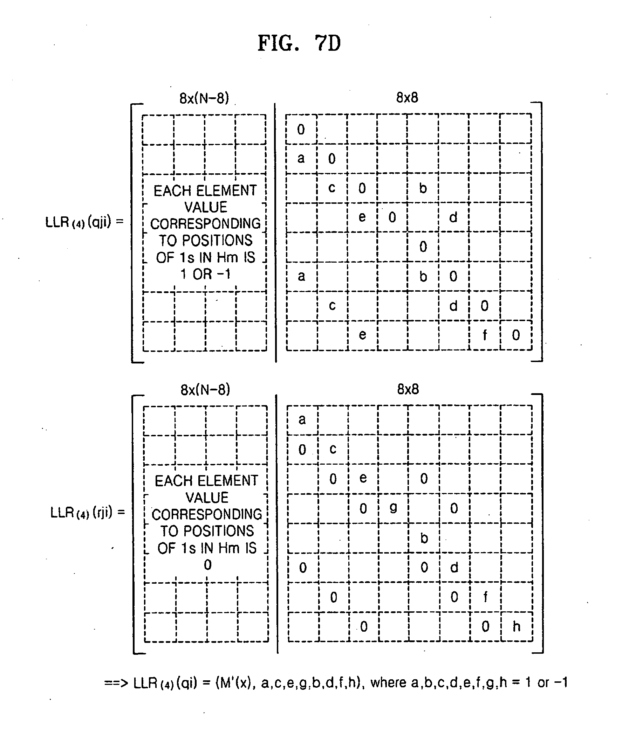

FIG. 7A is a diagram illustrating a first correction process when C'(x) = (M'(x), 0, 0, 0, 0, 0, 0, 0, 0). When a hard decision result of LLR₍₁₎(qi) is C₁(x), the decoding is terminated when HC₁^{T} = 0, and otherwise the correction is continued. FIG. 7B is a diagram illustrating a second correction process. When a hard decision result of LLR₍₂₎(qi) is C₂(x), the decoding is terminated when HC₂^{T}= 0, and otherwise the correction is continued. FIG. 7C is a diagram illustrating a third correction process. When a hard decision result of LLR₍₃₎(qi) is C₃(x), the decoding is terminated when HC₃^{T} = 0, and otherwise the correction is continued. FIG. 7D is a diagram illustrating a fourth correction process. When a hard decision result of LLR₍₄₎(qi) is C₄(x), HC₄^{T} = 0 and the decoding is terminated because C₄(x) must be C(x). The reason that C₄(x) must be C(x) is that a, b, c, d, e, f, g, h values of the parity portion are set by the decoding algorithm so that a matrix product of Aᵢ (a row vector in each operation) and Cᵢ(x) becomes 0.

According to an embodiment of the present invention, since the encoding is possible through the decoding, the encoding and the decoding can be achieved with only one decoder for a parity check matrix.

The invention can also be embodied as computer-readable codes on a computer-readable recording medium.

Although a few embodiments of the present invention have been shown and described, it would be appreciated by those skilled in the art that changes may be made in this embodiment without departing from the principles of the invention, the scope of which is defined in the claims and their equivalents.

## Claims

1. A method of encoding an N-M dimension data message vector, the encoding method comprising:
generating an M × N parity check matrix, H = [Hₘ|Hₚ], by generating an M × M sub-matrix, Hₚ, of the parity check matrix H, comprising an M number of row vectors that are linearly independent, a set A of the M number of the row vectors such that the set A is a union set of subsets A₁, A₂, ..., Aₖ, where 1 ≤ k ≤ M, that do not include intersection sets with each other and are not empty sets, the subset A₁ is a set of weight one row vectors among the row vectors of the set A, and a subset Aᵢ (2≤i ≤ k) is a set of row vectors capable of deriving a weight one row vector among row vectors not included in the union set of the subsets A₁, ..., Aᵢ₋₁ by performing a linear combination with row vectors in a union set of the subsets A₁, ... , Aᵢ₋₁;
wherein generating of the M × N parity check matrix comprises:
defining the parity check matrix to have a block structure, wherein M is a multiple of B, where B is an integer greater than one; and
generating at least a B number of weight one column vectors in the sub-matrix Hₚ;
**characterized by**:
encoding the message vector by setting an entire parity vector with 0s, replacing 0s of the message vector with -1s, and adding the parity vector having an M dimension to the message vector through soft-iterative decoding using the generated parity check matrix;
and wherein the block structure is such that M=8*B.

2. The method as claimed in claim 1, wherein the generating of the M × N parity check matrix comprises removing four cycles from the parity check matrix.

3. An error correction apparatus comprising:
a matrix generator to generate (630) an M × N parity check matrix, H = [Hₘ|Hₚ], where Hₘ is an M × (N-M) sub-matrix and Hₚ is an M × M sub-matrix comprising an M number of row vectors that are linearly independent, and a set A of the M number of the row vectors such that the set A is a union set of subsets A₁, A₂, ..., Aₖ, where 1 ≤ k ≤ M, that do not comprise intersection sets with each other and are not empty sets, the subset A₁ is a set of weight one row vectors among the row vectors of the set A, and the subset Aᵢ, where 2 ≤ i ≤ k, is a set of row vectors capable of deriving a weight one row vector among row vectors not included in the union set of the subsets A₁, ..., Aᵢ₋₁ by performing a linear combination with row vectors in a union set of the subsets Aᵢ, ... , Aᵢ₋₁ ;
a decoder (620) to encode a message vector of an N-M dimension by adding a parity vector having an M dimension and set entirely with 0s to the message vector through soft-iterative decoding using the generated parity check matrix, and to decode a received codeword vector; and
a decoder input (610) processor to replace 0s of the message vector with -1s, and to output the message vector with the replaced 0s into the decoder wherein the parity check matrix has a block structure, M = 8*B, where B is an integer greater than one, and the Hₚ comprises at least a B number of weight one column vectors.

4. The error correction apparatus as claimed in claim 4, wherein the parity check matrix does not comprise four cycles.

5. A computer readable recording medium encoded with the method of claim 1 implemented by a computer.

## Patentansprüche

1. Verfahren zum Codieren eines N-M Dimension-Datennachrichtenvektors, wobei das Codierungsverfahren umfasst:
Generieren einer M x N Paritätsprüfmatrix, H = [Hₘ|Hₚ], durch Generieren einer M x M Teilmatrix, Hₚ, der Paritätsprüfmatrix H, umfassend eine M Anzahl von Zeilenvektoren, die linear unabhängig sind, eine Menge A der M Anzahl der Zeilenvektoren so, dass die Menge A eine Vereinigungsmenge von Teilmengen A₁, A₂, ..., Aₖ ist, wobei 1 ≤ k ≤ M, die keine Schnittmengen miteinander enthalten und keine leeren Mengen sind, wobei die Teilmenge A₁ eine Menge von Zeilenvektoren, deren Gewicht eins ist, unter den Zeilenvektoren der Menge A ist und eine Teilmenge Aᵢ (2 ≤ i ≤ k) eine Menge von Zeilenvektoren ist, die durch Durchführen einer Linearkombination von Zeilenvektoren in einer Vereinigungsmenge der Teilmengen A₁, ..., Aᵢ₋₁ in der Lage ist, einen Zeilenvektor, dessen Gewicht eins ist, unter Zeilenvektoren, die nicht in der Vereinigungsmenge der Teilmengen A₁, ..., Aᵢ₋₁ enthalten sind, abzuleiten,
wobei das Generieren der M x N Paritätsprüfmatrix umfasst:
Definieren der Paritätsprüfmatrix so, dass sie eine Blockstruktur aufweist, wobei M ein Mehrfaches von B ist, wobei B eine Ganzzahl größer als eins ist, und
Generieren wenigstens einer B Anzahl von Säulenvektoren, deren Gewicht eins ist, in der Teilmatrix H_{p;}
**gekennzeichnet durch** Codierung des Nachrichtenvektors durch Einrichten eines gesamten Paritätsvektors mit Nullen, Ersetzen der Nullen des Nachrichtenvektors **durch** -Einsen und Addieren des Paritätsvektors, der eine M Dimension aufweist, zu dem Nachrichtenvektor **durch** schwache iterative Decodierung unter Verwendung der generierten Paritätsprüfmatrix,
wobei die Blockstruktur derartig ist, dass M = 8 * B ist.

2. Verfahren nach Anspruch 1, wobei das Generieren der M x N Paritätsprüfmatrix Entfernen von vier Zyklen aus der Paritätsprüfmatrix umfasst.

3. Fehlerkorrekturvorrichtung, umfassend:
einen Matrixgenerator (630) zum Generieren einer M x N Paritätsprüfmatrix, H = [Hₘ|Hₚ], wobei Hₘ eine M x (N-M) Teilmatrix ist und Hₚ eine M x M Teilmatrix ist, umfassend eine M Anzahl von Zeilenvektoren, die linear unabhängig sind, und eine Menge A der M Anzahl der Zeilenvektoren so, dass die Menge A eine Vereinigungsmenge von Teilmengen A₁, A₂, ... , Aₖ ist, wobei 1 ≤ k ≤ M, die keine Schnittmengen miteinander enthalten und keine leeren Mengen sind, wobei die Teilmenge A₁ eine Menge von Zeilenvektoren, deren Gewicht eins ist, unter den Zeilenvektoren der Menge A ist und die Teilmenge Aᵢ, wobei 2 ≤ i ≤ k, eine Menge von Zeilenvektoren ist, die durch Durchführen einer Linearkombination von Zeilenvektoren in einer Vereinigungsmenge der Teilmengen A₁, ..., Aᵢ₋₁ in der Lage ist, einen Zeilenvektor, dessen Gewicht eins ist, unter Zeilenvektoren, die nicht in der Vereinigungsmenge der Teilmengen A₁, ..., Aᵢ₋₁ enthalten sind, abzuleiten,
einen Decodierer (620) zum Codieren eines Nachrichtenvektors einer N-M Dimension durch Addieren eines Paritätsvektors, der eine M Dimension aufweist und vollständig mit Nullen eingerichtet ist, zu dem Nachrichtenvektor durch schwaches iteratives Decodieren unter Verwendung der generierten Paritätsprüfmatrix und zum Decodieren eines empfangenen Codewortvektors und
einen Decodierer-Eingabeprozessor (610) zum Ersetzen der Nullen des Nachrichtenvektors mit -Einsen und zum Ausgeben des Nachrichtenvektors mit den ersetzten Nullen in den Decodierer, wobei die Paritätsprüfmatrix eine Blockstruktur, M = 8 * B, aufweist, wobei B eine Ganzzahl größer als eins ist and die Hₚ wenigstens eine B Anzahl von Säulenvektoren, deren Gewicht eins ist, umfasst.

4. Fehlerkorrekturvorrichtung nach Anspruch 3, wobei die Paritätsprüfmatrix keine vier Zyklen umfasst.

5. Computerlesbares Aufzeichnungsmedium, codiert mit dem Verfahren nach Anspruch 1, implementiert durch einen Computer.

## Revendications

1. Procédé de codage d'un vecteur de message de données de N-M dimensions, le procédé de codage comportant l'étape consistant à :
générer une M x N matrice de contrôle de parité, H = [Hₘ|Hₚ], en générant une M x M sous-matrice, Hₚ, de la matrice de contrôle de parité H, comportant un M nombre de vecteurs de rangée qui sont indépendants de manière linéaire, un ensemble A du M nombre des vecteurs de rangée de sorte que l'ensemble A est un ensemble d'union de sous-ensembles A₁, A₂, ..., Aₖ où 1 ≤ k ≤ M, qui n'incluent pas d'ensembles d'intersection les uns avec les autres et ne sont pas des ensembles vides, le sous-ensemble A₁ est un ensemble de vecteurs de rangée de poids un parmi les vecteurs de rangée de l'ensemble A, et un sous-ensemble Aᵢ (2 ≤ i ≤ k) est un ensemble de vecteurs de rangée capable de dériver un vecteur de rangée de poids un parmi des vecteurs de rangée non inclus dans l'ensemble d'union des sous-ensembles A₁, ..., Aᵢ₋₁ en exécutant une combinaison linéaire avec des vecteurs de rangée dans un ensemble d'union des sous-ensembles A₁, ... , Aᵢ₋₁,
dans lequel la génération de la M x N matrice de contrôle de parité comporte les étapes consistant à :
définir la matrice de contrôle de parité pour avoir une structure de bloc, M étant un multiple de B, où B est un nombre entier supérieur à un, et
générer au moins un B nombre de vecteurs de colonne de poids un dans la sous-matrice Hₚ,
**caractérisé par** les étapes consistant à :
coder le vecteur de message en établissant un vecteur de parité entière avec les valeurs 0, remplacer les valeurs 0 du vecteur de message par les valeurs -1, et ajouter le vecteur de parité ayant une M dimension au vecteur de message via un décodage itératif souple utilisant la matrice de contrôle de parité générée,
et dans lequel la structure de bloc est telle que M = 8*B.

2. Procédé selon la revendication 1, dans lequel la génération de la M x N matrice de contrôle de parité comporte la suppression de quatre cycles de la matrice de contrôle de parité.

3. Dispositif de correction d'erreur comportant :
un générateur de matrice pour générer (630) une M x N matrice de contrôle de parité, H = [Hₘ|Hₚ], où Hₘ est une M x (N-M) sous-matrice et Hₚ est une M x M sous-matrice comportant un M nombre de vecteurs de rangée qui sont indépendants de manière linéaire, et un ensemble A du M nombre des vecteurs de rangée de sorte que l'ensemble A est un ensemble d'union de sous-ensembles A₁, A₂, ..., Aₖ où 1 ≤ k ≤ M, qui ne comportent pas des ensembles d'intersection les uns avec les autres et ne sont pas des ensembles vides, le sous-ensemble A₁ est un ensemble de vecteurs de rangée de poids un parmi les vecteurs de rangée de l'ensemble A, et le sous-ensemble Aᵢ, où 2 ≤ i ≤ k, est un ensemble de vecteurs de rangée capable de dériver un vecteur de rangée de poids un parmi des vecteurs de rangée non inclus dans l'ensemble d'union des sous-ensembles A₁, ..., Aᵢ₋₁ en exécutant une combinaison linéaire avec des vecteurs de rangée dans un ensemble d'union des sous-ensembles A₁, ..., Aᵢ₋₁,
un décodeur (620) pour coder un vecteur de message d'une N-M dimension en ajoutant un vecteur de parité ayant une M dimension et défini entièrement avec des valeurs 0 au vecteur de message via un décodage itératif souple utilisant la matrice de contrôle de parité générée, et pour décoder un vecteur de mot de code reçu, et
un processeur d'entrée de décodeur (610) pour remplacer les valeurs 0 du vecteur de message par les valeurs -1, et pour délivrer en sortie le vecteur de message avec les valeurs 0 remplacées dans le décodeur dans lequel la matrice de contrôle de parité a une structure de bloc, M = 8*B, où B est un nombre entier supérieur à un, et Hₚ comporte au moins un B nombre de vecteurs de colonne de poids un.

4. Dispositif de correction d'erreur selon la revendication 3, dans lequel la matrice de contrôle de parité ne comporte pas quatre cycles.

5. Support d'enregistrement lisible par ordinateur codé à l'aide du procédé de la revendication 1 mis en oeuvre par un ordinateur.
